# EUROPEAN PATENT APPLICATION

(11) **EP 0 957 517 A2**
(43) Date of publication of application: **17.11.1999**
(21) Application number: 99109639.7
(22) Date of filing: 14.05.1999
(51) Int. Cl.: H01L 23/04, H01L 23/10

(54) **Power semiconductor device**

(30) Priority: 15.05.1998 IT TO980414
(71) Applicant: ANSALDO TRASPORTI S.p.A., I-80147 Napoli (IT)
(72) Inventor: Zani, Pier Enrico, 16030 Cogorno (IT); Bellafronte, Elio, 16018 Mignanego (IT); Fasce, Fioravante, 16129 Genova (IT); Pasqualetti, Maurizio, 16159 Genova (IT); Portesine, Marco, 16143 Genova (IT)
(74) Representative: Eccetto, Mauro

(57) **Abstract**

A power semiconductor device wherein at least one stratified structure (3) - having a body of semiconducting material (6) forming at least one electronic component, and flat electric interconnecting and contact elements (8a, 8b; 9a, 9b) - is housed in a tubular body (4) made of plastic material and closed at opposite ends by respective substantially flat metal sealing walls (19, 20). Each metal sealing wall (19, 20) is annular, and has a peripheral edge (19a, 20a) glued (22) to a respective end portion (15, 16) of the tubular body.

## Description

The present invention relates to a power semiconductor device.

Power semiconductor devices are known in which a tubular insulating casing made of heat-resistant material (e.g. ceramic) houses a stratified structure comprising a flat body of semiconducting material forming at least one electronic component (diode, thyristor, GTO, IGBT, etc.), and flat electric interconnecting and contact elements.

The tubular casing has opposite end openings closed by respective metal plates, the peripheral edges of which are connected stably to annular flanges extending outwards, and from opposite end portions, of the tubular casing. The plates provide for sealing the insulating casing to separate the stratified structure completely from the environment surrounding the power semiconductor device.

Power semiconductor devices of the above type are normally sealed on forming machines for forming, e.g. by cold welding, a stable connection between the plate and annular flange. As stable connection normally calls for the application of considerable pressure, known forming machines generally have a complex, high-cost structure to enable such pressure to be applied while at the same time ensuring precise positioning of the plate with respect to the flange. Moreover, each forming machine is specially designed to produce a power semiconductor device of predetermined size, so that different power semiconductor devices of different sizes, e.g. different casing diameters, are generally produced on different and/or differently equipped forming machines.

It is an object of the present invention to provide a power semiconductor device which is cheap and easy to produce, and which, at the same time, ensures excellent sealing of the stratified structure inside the insulating casing.

According to the present invention, there is provided a power semiconductor device wherein at least one stratified structure is housed inside a casing; said stratified structure comprising: a body of semiconducting material forming at least one electronic component; electric interconnecting elements made of electric conducting material having a thermal expansion coefficient substantially equal to the thermal expansion coefficient of the body of semiconducting material, said electric interconnecting elements being located on opposite sides of said body of semiconducting material to form an electric contact with terminals of said electronic component; and electric contact elements made of electric conducting material and connected to and communicating electrically with respective electric interconnecting elements; said casing comprising at least one tubular body defining an inner cavity at least partially housing said stratified structure; characterized in that said tubular body is closed at opposite ends by respective substantially flat sealing walls; each said sealing wall having a peripheral edge connected by a glueing material to a portion of said tubular body.

According to the present invention, the insulating casing is sealed by a respective substantially flat sealing wall having a peripheral edge glued to an end portion of the insulating casing. The glueing operation is fast and cheap, and may be performed on forming and positioning machines of straightforward design, with no high pressure required.

A non-limiting embodiment of the invention will be described by way of example with reference to the accompanying drawings, in which:
Figure 1 shows a cross section of a power semiconductor device in accordance with the teachings of the present invention;
Figure 2 shows a first variation of the Figure 1 device;
Figure 3 shows a second variation of the Figure 1 device.

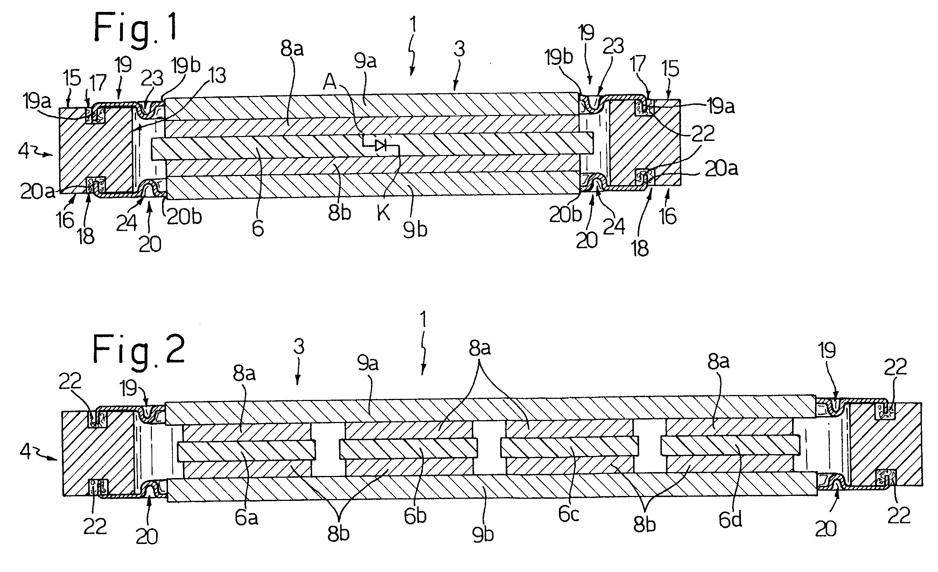

Number 1 in Figure 1 indicates as a whole a power semiconductor device wherein at least one stratified structure 3 is housed inside an insulating casing 4.

Stratified structure 3 comprises:
a body 6 made of semiconducting material (generally silicon with relative doped and metal portions) and comprising a flat circular or square plate forming at least one electronic component (diode, thyristor, IGBT, GTO, etc.) - the flat plate preferably has a surface area of over one sq.cm;
two electric interconnecting elements 8a, 8b comprising flat circular plates made of electric conducting material (e.g. molibdenum, tungsten, copper, etc.) having an expansion coefficient substantially equal to the expansion coefficient of body 6 - electric interconnecting elements 8a, 8b are located on opposite sides of body 6 to form respective electric contacts with a first and second terminal of the electronic component formed by body 6 (e.g. an anode A and a cathode K if the electronic component comprises a diode as shown in the Figure 1 example); and
two electric contact elements 9a, 9b comprising flat circular plates made of electric conducting material (e.g. copper, aluminium, etc.) - each electric contact element 9a, 9b is adjacent to, and establishes a stable electric connection with, a respective electric interconnecting element 8a, 8b.

A substantially equal expansion coefficient is intended to mean that the difference between the expansion coefficient of silicon and that of the electric interconnecting element does not exceed a maximum value of, say, 6 - 8 x 10⁻⁶ °C⁻¹. The table below shows, purely by way of example, the thermal expansion (values expressed in 10⁻⁶ °C⁻¹) of materials having an expansion coefficient substantially equal to that of silicon (values at 25°C).

| | |
|---|---|
| SILICON | 4.68 |
| MOLIBDENUM | 4.8 |
| TUNGSTEN | 4.5 |

The first and second terminal of the electronic component therefore communicate respectively with electric contact elements 9a, 9b via respective electric interconnecting elements 8a, 8b; and electric contact elements 9a, 9b each have a metal surface outside casing 4.

If the electronic component formed by body 6 of semiconducting material comprises a third (e.g. drive) terminal, the third terminal is normally connected to an electric conductor (not shown) insulated from electric interconnecting elements 8a, 8b and extending in sealed manner through and out of casing 4.

Casing 4 comprises a cylindrical tubular body defining a cylindrical inner cavity 13 in which stratified structure 3 is housed coaxially with cylindrical tubular body 4.

Tubular body 4 comprises flat annular end portions 15, 16 in which are formed respective annular grooves 17, 18, each with a substantially rectangular cross section.

Device 1 also comprises a pair of sealing walls 19, 20 for sealing respective opposite openings of tubular body 4.

More specifically, each sealing wall 19, 20 is substantially flat and annular, and comprises:
an outer peripheral edge 19a, 20a bent 90°, housed inside a respective groove 17, 18, and connected stably to tubular body 4 by a glueing material 22 (e.g. epoxy adhesive) inside groove 17, 18; and
an inner peripheral edge 19b, 20b connected stably (e.g. soldered) to a peripheral edge of a respective electric contact element 9a, 9b.

Each sealing wall 19, 20 comprises at least one controlled-deformation portion 23, 24, which is deformable to prevent force being transferred from stratified structure 3 to glueing material 22. More specifically, controlled-deformation portion 23, 24 comprises at least one portion of wall 19, 20 extending inside cavity 13 and having a substantially U-shaped section.

Tubular body 4 is made of plastic material (e.g. using so-called technopolymers) and is extremely resistant to heat and deformation.

The advantages of the present invention will be clear from the foregoing description : insulating casing 4 is sealed at each end by a respective sealing wall 19, 20, the peripheral edge 19a, 20a of which is glued to casing 4. After placing stratified structure 3 inside tubular body 4, glueing is effected by depositing a layer of adhesive inside groove 17, 18, positioning edge 19a, 20a facing the layer of adhesive, and inserting edge 19a, 20a inside groove 17, 18. The adhesive is then set and polymerized to form a stable connection between walls 19, 20 and tubular body 4. As the above operations call for little pressure and only straightforward positioning operations, the forming machines for producing the power semiconductor devices according to the present invention are of straightforward, low-cost mechanical design. Moreover, on account of the simplicity of the above sealing operations, the same forming machine may be adapted easily to produce semiconductor devices of different sizes, in particular with casings of different diameters.

Using a tubular body 4 made of plastic material, the power semiconductor device is extremely rigid, lightweight and cheap to produce.

The radial forces applied to annular portions 15, 16 by thermal expansion of electric contact elements 9a, 9b (during operation of the power semiconductor device) contribute towards deforming controlled-deformation portions 23, 24 so as to avoid stressing glueing material 22.

The Figure 2 device differs from the one in Figure 1 by stratified structure 3 comprising a number of bodies 6a, 6b, 6c, 6d of semiconducting material, each of which forms a respective electronic component and is connected to respective interconnecting elements 8a, 8b; interconnecting elements 8a are all adjacent to, and communicate electrically with, a single electric contact element 9a; interconnecting elements 8b are all adjacent to, and communicate electrically with, a single electric contact element 9b; and casing 4 therefore houses a number of electronic components arranged in parallel and having at least first terminals all communicating with electric contact element 9a, and second terminals all communicating with electric contact element 9b.

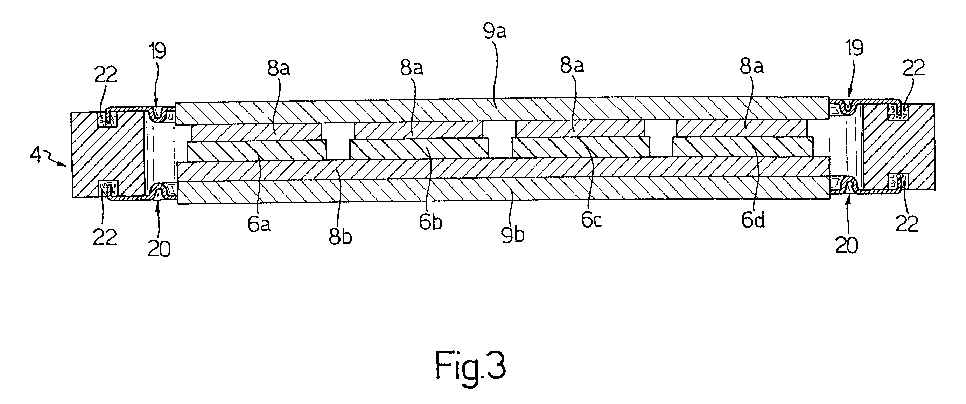

The Figure 3 device differs from those in Figures 1 and 2 by stratified structure 3 comprising a number of (separate) bodies 6a, 6b, 6c, 6d of semiconducting material, each of which forms a respective electronic component and is connected on one side to a respective interconnecting element 8a, and on the other side to a single interconnecting element 8b; interconnecting elements 8a are all adjacent to, and communicate electrically with, a single electric contact element 9a; and interconnecting element 8b is adjacent to, and communicates electrically with, a single electric contact element 9b. In this case, too, casing 4 therefore houses a number of electronic components arranged in parallel and having at least first terminals all communicating with electric contact element 9a, and second terminals all communicating with electric contact element 9b.

Clearly, changes may be made to the power semiconductor device as described herein without, however, departing from the scope of the present invention.

## Claims

1. A power semiconductor device wherein at least one stratified structure (3) is housed inside a casing (4); said stratified structure comprising:
- a body of semiconducting material (6) forming at least one electronic component;
- electric interconnecting elements (8a, 8b) made of electric conducting material having a thermal expansion coefficient substantially equal to the thermal expansion coefficient of the body of semiconducting material (6); said electric interconnecting elements (8a, 8b) being located on opposite sides of said body of semiconducting material (6) to form an electric contact with terminals (A, K) of said electronic component; and
- electric contact elements (9a, 9b) made of electric conducting material and connected to and communicating electrically with respective electric interconnecting elements (8a, 8b);
said casing comprising at least one tubular body (4) defining an inner cavity (13) at least partially housing said stratified structure (3);
characterized in that said tubular body (4) is closed at opposite ends by respective substantially flat sealing walls (19, 20); each said sealing wall (19, 20) having a peripheral edge (19a, 20a) connected by a glueing material (22) to a portion (15, 16) of said tubular body (4).

2. A device as claimed in Claim 1, characterized in that said peripheral edge (19a, 20a) is connected by said glueing material (22) to an end portion (15, 16) of said tubular body (4).

3. A device as claimed in Claim 1 or 2, characterized in that each sealing wall (19, 20) is substantially annular, and comprises an outer peripheral edge (19a, 20a) connected stably by said glueing material (22) to said portion (15, 16) of the tubular body (4), and an inner peripheral edge (19b, 20b) connected stably to a respective electric contact element (9a, 9b).

4. A device as claimed in any one of the foregoing Claims, characterized in that each sealing wall (19, 20) comprises at least one controlled-deformation portion (23, 24) which is deformable to prevent force being transferred by said stratified structure (3) to said glueing material (22).

5. A device as claimed in Claim 4, characterized in that said controlled-deformation portion (23, 24) comprises at least one portion of said sealing wall (19, 20) having a substantially U-shaped section.

6. A device as claimed in any one of the foregoing Claims, characterized in that said tubular body (4) is made of plastic material.

7. A device as claimed in any one of the foregoing Claims, characterized in that said stratified structure comprises a number of separate bodies of semiconducting material (6), each forming at least one respective electronic component.
